Europäisches Patentamt

European Patent Office

Office européen des brevets

(11) Veröffentlichungsnummer : **0 013 876**
**B1**

(12) **EUROPÄISCHE PATENTSCHRIFT**

(45) Veröffentlichungstag der Patentschrift :
05.10.83

(21) Anmeldenummer : **80100017.5**

(22) Anmeldetag : **03.01.80**

(51) Int. Cl.³ : **G 01 R 31/28,** H 01 J 49/48,
H 01 J 37/26

(54) **Einrichtung zur berührungslosen Potentialmessung.**

(30) Priorität : **23.01.79 DE 2902495**

(43) Veröffentlichungstag der Anmeldung :
**06.08.80 Patentblatt 80/16**

(45) Bekanntmachung des Hinweises auf die Patenterteilung : **05.10.83 Patentblatt 83/40**

(84) Benannte Vertragsstaaten :
**GB NL**

(56) Entgegenhaltungen :
**REVIEW OF SCIENTIFIC INSTRUMENTS, Band 48, Nr. 3, März 1977, W.J. TEE et al. : « Improved voltage measurement system using the scanning electron microscope », Seiten 350-355**

(73) Patentinhaber : **SIEMENS AKTIENGESELLSCHAFT Berlin und München Wittelsbacherplatz 2 D-8000 München 2 (DE)**

(72) Erfinder : **Feuerbaum, Hans-Peter Dipl.-Phys Tucholskystrasse 22 D-8000 München 83 (DE)**

Einrichtung zur berührungslosen Potentialmessung

Die Erfindung bezieht sich auf eine Einrichtung zur berührungslosen Potentialmessung mit einem Primärelektronenstrahl, welcher an der Meßstelle eines elektronischen Bauelementes, vorzugsweise eines integrierten Schaltkreises, Sekundärelektronen auslöst, deren Energie mit einem eine Detektoranordnung enthaltenden Spektrometer bestimmt wird, wobei in verschiedenen Abständen der Meßstelle nacheinander eine Absaugelektrode und eine Gegenfeldelektrode angeordnet sind, die als Gitterelektroden gestaltet und wenigstens annähernd senkrecht zum Primärelektronenstrahl angeordnet sind.

Zur Funktionsprüfung elektronischer Bauelemente, insbesondere integrierter Schaltkreise, können bekanntlich berührungslose Potentialmessungen mit einem Elektronenmikroskop, vorzugsweise einem Rasterelektronenmikroskop, durchgeführt werden. Das Elektronenmikroskop besteht im wesentlichen aus einer elektronenoptischen Säule, die eine sogenannte Elektronenkanone enthält und im allgemeinen mit einer Einrichtung zum Tasten des Elektronenstrahls und zur Ablenkung des Elektronenstrahls versehen ist. Diese Einrichtungen sind innerhalb der Säule im Vakuum angeordnet. Das zu untersuchende Bauelement befindet sich außerhalb der elektronenoptischen Säule in einer Probenkammer, in der sich der Elektronenkollektor des Spektrometers befindet und die ebenfalls evakuiert ist.

Der Primärelektronenstrahl löst an der Meßstelle aus einer Leiterbahn des Bauelements Sekundärelektronen aus, die von einem Elektronenkollektor gesammelt und in elektrische Signale umgewandelt werden. Die Zahl der vom Primärelektronenstrahl an der Meßstelle ausgelösten Sekundärelektronen ist abhängig vom Potential an der Meßstelle. Für quantitative Potentialmessung ist das Elektronenmikroskop mit einem Spektrometer, beispielsweise einem Gegenfeld-Spektrometer, versehen, das einen zylindrischen Ablenkkondensator enthält, der die Sekundärelektronen durch ein Verzögerungsfeld dem Elektronenkollektor zuführt, der das Elektronensignal in ein entsprechendes elektrisches Signal umwandelt und einen Regelverstärker steuert. Das Ausgangssignal des Verstärkers steuert über eine Rückkopplung das Spektrometer. Die Gitterspannung an der Gegenfeldelektrode wird so lange nachgeregelt, bis die Spannung zwischen Gitter und Meßpunkt wieder ihren ursprünglichen konstanten Wert erreicht hat. Dann entspricht die Änderung der Gitterspannung direkt der Potentialänderung an der Meßstelle der Probe.

Es ist bekannt, daß eine Funktionsprüfung von integrierten Schaltkreisen möglich ist, die sich auf einem Wafer befinden und somit noch nicht mit elektrischen Anschlüssen versehen sind. Bei diesem Verfahren kann mit Hilfe einer sogenannten Prüfkarte (wafer prober), die mit Spitzen versehen ist, durch Aufsetzen der Spitzen auf vorbestimmte Oberflächenteile, sogenannte Pats, die Funktion der Bauelemente geprüft werden. Diese Flächeneinheiten haben eine Kantenlänge von beispielsweise 50 · 50 μm. Die Messung erstreckt sich somit auf Teile des Bauelements, die später am Sockel mit einem Anschlußleiter versehen werden. Die mit diesen aufgesetzten Spitzen gemessenen elektrischen Signale werden einem Computer zugeführt, der die Funktion des Bauelements überprüft (« Micro analytical probing system » der Firma POLYTEC).

Quantitative Potentialmessungen zur Überprüfung der Funktion der Halbleiterbauelemente auch an schmalen Leiterbahnen innerhalb einer Schaltung, deren Breite nur wenige Mikrometer, beispielsweise weniger als 4 μm beträgt, können mit dem Primärelektronenstrahl eines Rasterelektronenmikroskops ausgeführt werden. Zu diesem Zweck muß jedoch das zur Erfassung der Sekundärelektronen vorgesehene Spektrometer in eine entsprechende Bohrung der Prüfkarte eingesetzt werden und in dieser Bohrung auch noch in der Oberflächenebene des Bauelements verschiebbar sein. Außerdem existieren an der Oberfläche integrierter Schaltkreise lokale elektrostatische Felder, welche die ausgelösten niederenergetischen Sekundärelektronen auf die Schaltkreisoberfläche zurücktreiben und somit Meßfehler verursachen.

Aus « Review of Scientific Instruments », Bd. 48, Nr. 3, März 1977, W. J. Tee et al. : « Improved Voltage Measurement System Using the Scanning Electron Microscope », Seiten 350-355, ist eine Einrichtung der eingangs genannten Art bekannt, bei welcher halbkugelförmige Absaug- und Gegenfeldelektroden Verwendung finden. Zum Nachweis der Sekundärelektronen ist bei dieser bekannten Einrichtung eine halbkugelförmige Detektionselektrode vorgesehen, die an ein Elektrometer angeschlossen ist.

Der Durchmesser des Primärelektronenstrahls ist wesentlich abhängig vom Arbeitsabstand. Der vorliegenden Erfindung liegt die Aufgabe zugrunde, eine Einrichtung der eingangs genannten Art anzugeben, welche zur Potentialmessung an schmalen Leiterbahnen geeignet ist und bei der zur Verbesserung der Nachweisempfindlichkeit der Primärelektronenstrahl von der Detektoranordnung abgeschirmt ist. Darüber hinaus muß das Spektrometer für verschiedene Prüfkarten und auch für die Untersuchung einzelner aufgebauter integrierter Schaltkreise, die bereits mit ihren elektrischen Anschlüssen (Bond-Drähten) versehen sind, verwendbar sein.

Diese Aufgabe wird erfindungsgemäß durch eine Einrichtung der eingangs genannten Art gelöst, welche zwischen der Gegenfeldelektrode und der Detektoranordnung des Spektrometers eine zusätzliche Absaugelektrode aufweist, wobei die zusätzliche Absaugelektrode und die Gegenfeldelektrode in Ebenen liegen, die miteinander einen Winkel einschließen.

Durch die Anordnung des Saugnetzes in einem sehr geringen Abstand von der Meßstelle erhält man an der Meßstelle eine entsprechend hohe Feldstärke, die verhindert, daß Sekundärelektronen durch Streufelder zur Oberfläche des Bauelements zurückgetrieben werden. Das Saugnetz ersetzt somit die übliche Wehnelt-Elektrode in Verbindung mit einer Anode. Die Gegenfeldelektrode bremst die auf hohe Energie beschleunigten Sekundärelektronen ab und treibt den niederenergetischen Teil dieser Elektronen auf das Bauelement zurück. Durch das Gegenfeldnetz treten somit nur die hochenergetischen Elektronen hindurch.

Diese hochenergetischen Elektronen werden von der zusätzlichen Absaugelektrode abgesaugt. Diese zweite Saugelektrode zieht die Sekundärelektronen zu der Detektoranordnung ab und wirkt zugleich als Abschirmung zwischen dem Primärelektronenstrahl und der Detektoranordnung, an der im allgemeinen eine verhältnismäßig hohe Spannung von beispielsweise 10 kV and mehr anliegt.

Eine bevorzugte Ausführungsform einer Spektrometeranordnung besteht darin, daß metallische Teile mit einem Fangnetz für rückgestreute Elektronen versehen sind. Die an der Meßstelle ausgelösten schnellen Elektronen mit entsprechend hoher Energie können an anderen Spektrometerteilen Sekundärelektronen auslösen, die dann zum der Detektoranordnung gelangen können und das Meßergebnis stören würden. Das in einem vorbestimmten Abstand von den Spektrometerteilen angeordnete Fangnetz ist gegenüber dem Gehäuse des Spektrometers negativ geladen und hält dann die an dem Gehäuse ausgelösten Sekundärelektronen zurück. Diese Sekundärelektronen können somit das Gegenfeld des Fangnetzes nicht überwinden. Damit ist eine Störung des Meßergebnisses durch diese rückgestreuten Elektronen ausgeschlossen.

Die Detektoranordnung kann vorzugsweise einen Szintillator für die Sekundärelektronen enthalten, der mit einem verhältnismäßig dünnen Lichtleiter versehen ist, der die im Szintillator ausgelösten Photonen zum Detektor des Spektrometers leitet.

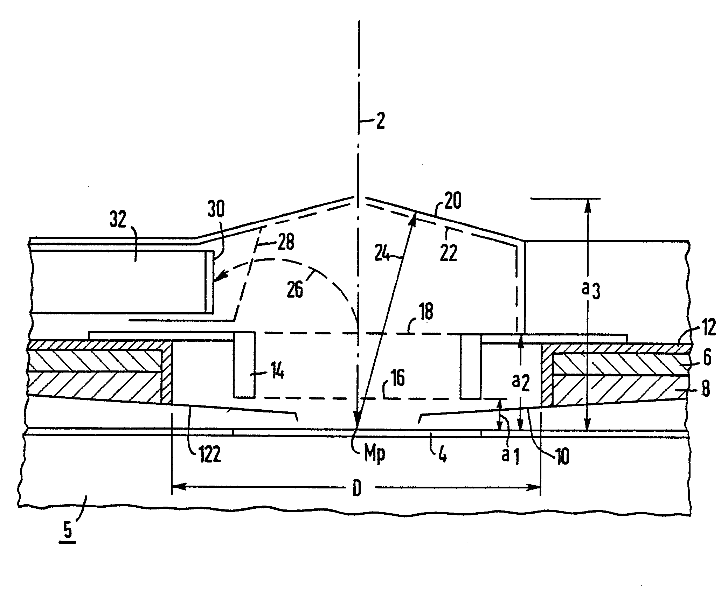

Zur weiteren Erläuterung der Erfindung wird auf die Zeichnung Bezug genommen, in der ein Teil eines Rasterelektronenmikroskops nach der Erfindung schematisch veranschaulicht ist.

Entsprechend der Figur wird ein Primärelektronenstrahl 2, der in einer in der Figur nicht dargestellten sogenannten elektronenoptischen Säule erzeugt ist, dem Meßpunkt Mp eines elektronischen Bauelements 4 zugeführt, das vorzugsweise ein integrierter Schaltkreis sein kann und mit weiteren nicht näher bezeichneten Bauelementen auf der Oberfläche eines Wafers 5 angeordnet ist. Die elektronenoptische Säule des Rasterelektronenmikroskops enthält im allgemeinen eine Elektronenkanone, die im wesentlichen aus einer Kathode und einer Wehnelt-Elektrode und einer Anode besteht, sowie eine Tasteinrichtung für den Primärelektronenstrahl 2 und eine Ablenkeinrichtung, mit deren Hilfe der Elektronenstrahl auf dem elektronischen Bauelement 4 positioniert werden kann. Das Bauelement 4 befindet sich innerhalb einer Bohrung mit dem Durchmesser D von beispielsweise 25 mm einer Kunststoffplatine 6. Unter der Platine selbst ist ein Kunststoffring 8 angeordnet, in dessen unterer Oberfläche Meßspitzen 10 und 122 eingebettet sind. Innerhalb der Bohrung sind Abstandshalter 14 parallel zur oberen Flachseite des Bauelements 4 auf einer Führung 12 verschiebbar gelagert. In einem vorzugsweise sehr geringen Abstand $a_1$ von beispielsweise weniger als 1 mm, insbesondere weniger als 0,5 mm, ist im wesentlichen parallel zur Oberfläche des Bauelements 4 eine erste Gitterelektrode angeordnet, die als Absaugelektrode 16 dient. Oberhalb der Absaugelektrode ist im Abstand $a_2$ von dem Meßpunkt Mp eine Gegenfeldelektrode 18 vorgesehen, die vorzugsweise ebenfalls als Netz gestaltet sein kann. Der Raum oberhalb des Bauelements 4 ist durch einen Deckel 20 abgeschlossen, der gegen die in der Figur nicht dargestellte Polplatte des Rasterelektronenmikroskops isoliert ist. Parallel zu dem Deckel 20 und in einem vorzugsweise geringen Abstand von beispielsweise wenigen Zehntel Millimetern ist ein Fangnetz 22 vorgesehen, das als Elektronenfalle für rückgestreute Elektronen dient, die am Meßpunkt Mp ausgelöst werden und die Gegenfeldelektrode 18 überwinden, wie in der Figur durch einen Pfeil 24 angedeutet ist. Dieses Fangnetz 22 kann vorzugsweise auch noch vor anderen metallischen Teilen der Kammer angeordnet sein, beispielsweise vor den nicht mehr bezeichneten Seitenwänden.

Die Sekundärelektronen 26 werden von einer zweiten Absaugelektrode 28, die vorzugsweise ebenfalls als Netz gestaltet sein kann, abgesaugt und gelangen zum Szintillator 30 eines Spektrometers des Rasterelektronenmikroskops. Sie bilden in bekannter Weise im Szintillator 30 Photonen, die mit einem Lichtleiter 32 zum in der Figur nicht dargestellten Detektor des Spektrometers gelangen. Durch die Anordnung der ersten Saugelektrode 16 in Verbindung mit der Gegenfeldelektrode 18 kann die Bauhöhe $a_3$ auf wenige Millimeter, beispielsweise nicht wesentlich mehr als 7 mm, begrenzt werden.

Durch diese geringe Bauhöhe des Spektrometers mit entsprechend geringem Arbeitsabstand erhält man eine gute Fokussierung des Elektronenstrahls 2 mit einem entsprechend geringen Durchmesser.

Durch den geringen Abstand $a_1$ des Gitters der Absaugelektrode 16 vom Meßpunkt Mp erhält man eine hohe Feldstärke von vorzugsweise wenigstens 5 kV/cm an der Oberfläche des Bauelements 4. Damit wird verhindert, daß am Meßpunkt Mp ausgelöste niederenergetische Sekundärelektronen durch elektrostatische Störfelder auf die Oberfläche des Bauelements 4 zu-

rückgetrieben werden, wodurch die Energieverteilung der Sekundärelektronen verfälscht und somit Meßfehler verursacht würden. Man erhält somit eine ungestörte Energieverteilung an der nachfolgenden Gegenfeldelektrode 18.

Die zur Verarbeitung des elektrischen Signals des Spektrometers übliche Regeleinrichtung kann eine hohe Bandbreite nur erreichen, wenn das Spektrometer eine integrale Energieverteilung liefert. Dies erreicht man durch die Anordnung der Gegenfeldelektrode 18 in Verbindung mit den beiden Absaugelektroden 16 und 28.

In der dargestellten Ausführungsform des Rasterelektronenmikroskops ist das Spektrometer geeignet sowohl für verschiedene Wafer-Prober und auch für die Untersuchung einzelner aufgebauter integrierter Schaltkreise. Zum kontrollierten Aufsetzen der Spitzen 10 und 12 kann das gesamte Bauelement 4 vom Primärelektronenstrahl 2 abgerastert werden. Zur Positionierung des Primärelektronenstrahls 2 wird der gewünschte Oberflächenbereich des Bauelements 4 bei hoher Vergrößerung von beispielsweise 1 000 in die Mitte des Spektrometers gebracht. Die erste Absaugelektrode 16 und die Gegenfeldelektrode 18 sind dabei so zur optischen Achse des Rasterelektronenmikroskops justiert, daß die Netze dieser Elektroden bei hoher Vergrößerung nicht abgebildet werden.

Zur Potentialmessung werden die an der Meßstelle Mp ausgelösten Sekundärelektronen von der ersten Absaugelektrode 16 in das Gegenfeld der Elektrode 18 beschleunigt. Die höherenergetischen Sekundärelektronen durchlaufen die Gegenfeldelektrode 18 und werden von der zweiten Absaugelektrode 28 zum Szintillator 30 beschleunigt. Die zweite Absaugelektrode 28 dient zugleich zur Abschirmung des Primärelektronenstrahls 2 gegen den Szintillator 30, an dem eine hohe Spannung von beispielsweise 15 kV anliegt.

Rückgestreute Elektronen mit entsprechend hoher Energie können zwar an den Metallteilen, beispielsweise dem Deckel 20, sekundärelektronen auslösen, diese werden aber durch das Fangnetz 22 zurückgehalten und können dieses Gegenfeld nicht überwinden.

Mit einem in der Figur nicht dargestellten Umschalter können die Spannungen an der Gegenfeldelektrode 18 und dem Fangnetz 22 so geändert werden, daß nur die rückgestreuten Elektronen der metallischen Teile, beispielsweise des Deckels 20, vom Detektor des Spektrometers erfaßt werden.

## Ansprüche

1. Einrichtung zur berührungslosen Potentialmessung mit einem Primärelektronenstrahl (2), welcher an der Meßstelle (Mp) eines elektronischen Bauelements (4), vorzugsweise eines integrierten Schaltkreises, Sekundärelektronen (26) auslöst, deren Energie mit einem eine Detektoranordnung enthaltenden Spektrometer bestimmt wird, wobei in verschiedenen Abständen ($a_1$, $a_2$)

von der Meßstelle (Mp) nacheinander eine Absaugelektrode (16) und eine Gegenfeldelektrode (18) angeordnet sind, die als Gitterelektroden gestaltet und wenigstens annähernd senkrecht zum Primärelektronenstrahl (2) angeordnet sind, dadurch gekennzeichnet, daß zwischen der Gegenfeldelektrode (18) und der Detektoranordnung (30, 32) des Spektrometers eine zusätzliche Absaugelektrode (28) vorgesehen ist, wobei die zusätzliche Absaugelektrode (28) und die Gegenfeldelektrode in Ebenen liegen, die miteinander (18) einen Winkel einschließen.

2. Einrichtung nach Anspruch 1, dadurch gekennzeichnet, daß metallische Teile des Spektrometers mit einem Fangnetz (22) für rückgestreute Elektronen versehen sind.

## Claims

1. Apparatus for the non-contact measurement of potential by means of a primary electron beam (2), which at the measuring point (Mp) of an electronic component (4), preferably an integrated circuit, releases secondary electrons, the energy of which is determined by means of a spectrometer including a detector arrangement, in which at different distances ($a_1$, $a_2$) from the measuring point (Mp), there are consecutively arranged a collector electrode (16) and a counterfield electrode (18) which are in the form of grid electrodes and are arranged so as to be at least approximately at right angles to the primary electron beam (2), characterised in that an additional collector electrode (28) is arranged between the counter-field electrode (18) and the detector arrangement (30, 32) of the spectrometer, the additional collector electrode (28) and the counterfield electrode (18) being arranged in planes which are at an angle to one another.

2. Apparatus as claimed in Claim 1, characterised in that metal components of the spectrometer are provided with a collecting grid (22) for backscattered electrons.

## Revendications

1. Appareil pour mesurer sans contact un potentiel avec un rayon électronique primaire (2) qui libère au point de mesure (Mp) d'un composant électronique (4), de préférence d'un circuit de commutation intégré, des électrons secondaires (26) dont l'énergie est déterminée avec un spectromètre contenant un dispositif détecteur, du type dans lequel, à des distances différentes ($a_1$, $a_2$) du point de mesure (Mp), sont disposées successivement une électrode d'extraction (16) et une électrode de champ inverse (18) qui sont réalisées comme électrodes à grilles et sont disposées au moins à peu près perpendiculairement au rayon électronique primaire (2), caractérisé par le fait qu'entre l'électrode de champ inverse (18) et le dispositif détecteur (30, 32) du spectromètre, est prévue une électrode d'extraction supplémentaire (28), l'électrode d'extraction supplémentaire (28) et l'électrode de champ inverse (18) se situant dans des plans formant entre eux un angle.

2. Appareil selon la revendication 1, caractérisé par le fait que des parties métalliques du spectromètre sont pourvues d'une grille d'arrêt (22) pour les électrons de rétro-diffusion.